# EUROPEAN PATENT APPLICATION

(11) **EP 3 926 679 A1**
(43) Date of publication of application: **22.12.2021**
(21) Application number: 20180535.5
(22) Date of filing: 17.06.2020
(51) Int. Cl.: H01L 25/07, H01L 23/34, H01L 23/49

(54) **POWER SEMICONDUCTOR MODULE ARRANGEMENT COMPRISING A TEMPERATURE SENSOR**

(71) Applicant: Infineon Technologies AG, 85579 Neubiberg (DE)
(72) Inventor: JANSEN, Uwe, 59457 Werl (DE); ARENS, Andre, 59602 Ruethen (DE); KRUSCHEL, Wolfram, 44141 Dortmund (DE)
(74) Representative: Westphal, Mussgnug & Partner, Patentanwälte mbB

(57) **Abstract**

A power semiconductor module arrangement (100) comprises a substrate (10) comprising a dielectric insulation layer (11), and a first metallization layer (111) arranged on a first side of the dielectric insulation layer (11), at least one semiconductor die (20) mounted on the first metallization layer (111) of the substrate (10), and at least one temperature sensor arrangement. Each of the at least one temperature sensor arrangement comprises a temperature sensor (210), a first connection piece (32), thermally and electrically coupling the temperature sensor (210) to one of the at least one semiconductor die (20), and a second connection piece (34), electrically coupling the temperature sensor (210) to a first sense terminal element (42). A maximum dimension of a cross-section of the first connection piece (32) of each of the at least one temperature sensor arrangement is greater than a maximum dimension of a cross-section of the respective second connection piece (34).

## Description

### TECHNICAL FIELD

The instant disclosure relates to a power semiconductor module arrangement, in particular to a power semiconductor module arrangement comprising at least one temperature sensor arrangement.

### BACKGROUND

Power semiconductor module arrangements often include at least one semiconductor substrate arranged in a housing. A semiconductor arrangement including a plurality of semiconductor elements (e.g., two IGBTs in a half-bridge configuration) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The semiconductor elements are mounted, for example, on the first metallization layer. The second metallization layer may optionally be attached to a base plate. The semiconductor devices are usually mounted onto the semiconductor substrate by soldering or sintering techniques.

During operation of the power semiconductor module arrangement, the semiconductor elements may generate heat, e.g., in consequence of performing switching processes. In order to prevent the power semiconductor module arrangement, and in particular the semiconductor elements, from overheating, usually a temperature of the power semiconductor module arrangement is monitored. If a certain threshold temperature is exceeded, the power semiconductor module arrangement may be switched off, or the switching frequency may be reduced until the temperature has dropped below the temperature threshold.

Therefore, the power semiconductor module arrangement may comprise at least one temperature sensor arrangement. Often, a single temperature sensor is used to determine a temperature of the power semiconductor module arrangement. The performed measurements, however, are often imprecise as some power semiconductor devices are located at a significant distance from the temperature sensor. Using more than one temperature sensor within one power semiconductor module arrangement is usually not an option as the temperature sensors and the electrical connections that are required to read out the measurement results require a significant amount of space within the power semiconductor module arrangement.

There is a need for a power semiconductor module arrangement comprising a temperature sensor arrangement that allows to reliably monitor temperature changes of the power semiconductor module arrangement without being excessively large and costly.

### SUMMARY

A power semiconductor module arrangement includes a substrate including a dielectric insulation layer, and a first metallization layer arranged on a first side of the dielectric insulation layer, at least one semiconductor die mounted on the first metallization layer of the substrate, and at least one temperature sensor arrangement. Each of the at least one temperature sensor arrangement comprises a temperature sensor, a first connection piece, thermally and electrically coupling the temperature sensor to one of the at least one semiconductor die, and a second connection piece, electrically coupling the temperature sensor to a first sense terminal element. A maximum dimension of a cross-section of the first connection piece of each of the at least one temperature sensor arrangement is greater than a maximum dimension of a cross-section of the respective second connection piece.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a top view of a power semiconductor module arrangement.
Figure 3 is a top view of a power semiconductor module arrangement according to one example.
Figure 4 is a top view of a power semiconductor module arrangement according to another example.
Figure 5 is a cross-sectional view of a controllable semiconductor element that is coupled to a temperature sensor arrangement according to one example.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not necessarily require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor die has electrically connectable pads and includes at least one semiconductor element with electrodes.

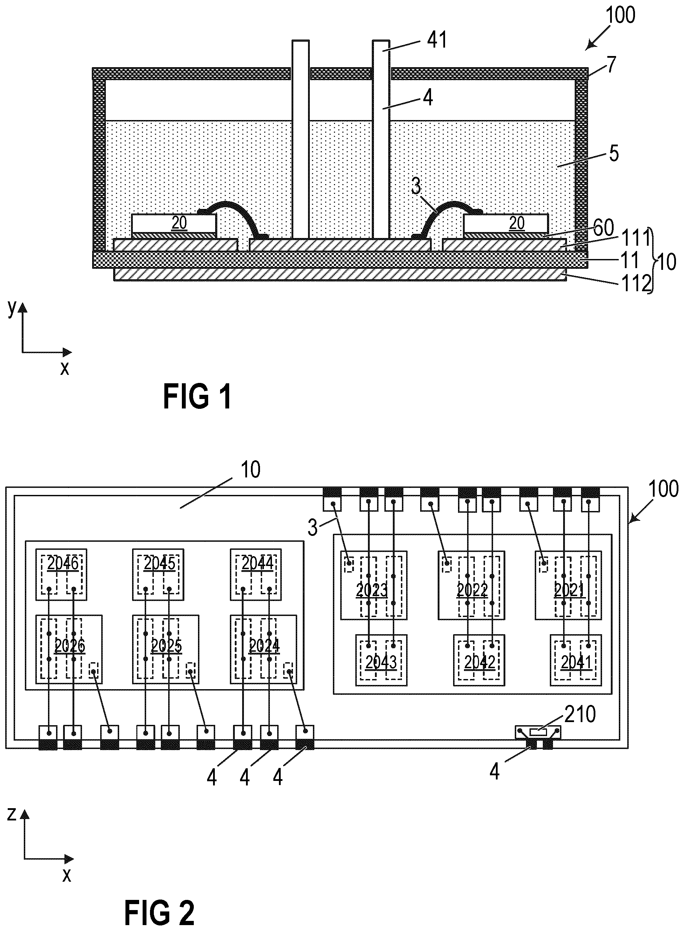

Referring to Figure 1, a cross-sectional view of a power semiconductor module arrangement 100 is illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. Alternatively, the dielectric insulation layer 11 may consist of an organic compound and include one or more of the following materials: Al₂O₃, AlN, SiC, BeO, BN, or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., Si₂O, Al₂O₃, AlN, SiN or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 forms a base surface of the housing 7, while the housing 7 itself solely comprises sidewalls and a cover. This, however, is only an example. It is also possible that the housing 7 further comprises a base surface and the substrate 10 is arranged on the base surface inside the housing 7. According to another example (not specifically illustrated), the substrate 10 may be mounted on a base plate. The base plate may form a bottom of the housing 7. In some power semiconductor module arrangements 100, more than one substrate 10 is arranged within the same housing 7.

One or more semiconductor dies 20 may be arranged on the at least one substrate 10. Each of the semiconductor dies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor dies 20 may form a semiconductor arrangement on the substrate 10. In Figure 1, only two semiconductor dies 20 are exemplarily illustrated. The second metallization layer 112 of the substrate 10 in Figure 1 is a continuous layer. According to another example, the second metallization layer 112 may be a structured layer. According to other examples, the second metallization layer 112 may be omitted. The first metallization layer 111 is a structured layer in the example illustrated in Figure 1. "Structured layer" in this context means that the respective metallization layer is not a continuous layer, but includes recesses between different sections of the layer. Such recesses are schematically illustrated in Figure 1. The first metallization layer 111 in this example includes three different sections. Different semiconductor dies 20 may be mounted to the same or to different sections of the first metallization layer 111. Different sections of the first metallization layer may have no electrical connection or may be electrically connected to one or more other sections using electrical connections 3 such as, e.g., bonding wires. Semiconductor dies 20 may be electrically connected to each other or to the first metallization layer 111 using electrical connections 3, for example. Electrical connections 3, instead of bonding wires, may also include bonding ribbons, connection plates or conductor rails, for example, to name just a few examples. The one or more semiconductor dies 20 may be electrically and mechanically connected to the substrate 10 by an electrically conductive connection layer 60. Such an electrically conductive connection layer 60 may be a solder layer, a layer of an electrically conductive adhesive, or a layer of a sintered metal powder, e.g., a sintered silver (Ag) powder, for example.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end, while a second end 41 of the terminal elements 4 protrudes out of the housing 7. The terminal elements 4 may be electrically contacted from the outside at their second end 41. Such terminal elements 4, however, are only an example. The components inside the housing 7 may be electrically contacted from outside the housing 7 in any other suitable way. For example, terminal elements 4 may be arranged closer to or adjacent to the sidewalls of the housing 7. It is also possible that terminal elements 4 protrude vertically or horizontally through the sidewalls of the housing 7. It is even possible that terminal elements 4 protrude through a ground surface of the housing 7. The first end of a terminal element 4 may be electrically and mechanically connected to the substrate 10 by an electrically conductive connection layer, for example (not explicitly illustrated in Figure 1). Such an electrically conductive connection layer may be a solder layer, a layer of an electrically conductive adhesive, or a layer of a sintered metal powder, e.g., a sintered silver (Ag) powder, for example. The first end of a terminal element 4 may also be electrically coupled to the substrate via one or more electrical connections 3, for example.

The power semiconductor module arrangement 100 generally further includes a encapsulant 5. The encapsulant 5 may consist of or include a silicone gel or may be a rigid molding compound, for example. The encapsulant 5 may at least partly fill the interior of the housing 7, thereby covering the components and electrical connections that are arranged on the substrate 10. The terminal elements 4 may be partly embedded in the encapsulant 5. At least their second ends 41, however, are not covered by the encapsulant 5 and protrude from the encapsulant 5 through the housing 7 to the outside of the housing 7. The encapsulant 5 is configured to protect the components and electrical connections of the power semiconductor module 100, in particular the components arranged inside the housing 7, from certain environmental conditions and mechanical damage. It is generally also possible to omit the housing 7 and solely protect the substrate 10 and any components mounted thereon with an encapsulant 5. In this case, the encapsulant 5 may be a rigid material, for example.

At least some semiconductor dies 20 of the power semiconductor module arrangement 100 generally perform a plurality of switching operations during the operation of the power semiconductor module arrangement 100. When performing many switching operations within a short period of time, the semiconductor dies 20 generate heat which, in the worst case, may rise to a temperature above a certain maximum threshold. Temperatures above such a maximum threshold may adversely affect the operation of the power semiconductor module, or even lead to the total failure of one or more semiconductor dies 20.

Therefore, a temperature of the power semiconductor module arrangement 100 is monitored. This temperature, for example, may be a temperature of one or more of the semiconductor dies 20. If it is detected, that the temperature exceeds a certain threshold, the power semiconductor module arrangement 100 may be switched off, or the switching frequency may be reduced until the temperature has dropped to below the temperature threshold. Once the temperature has dropped below the threshold, normal operation of the power semiconductor module arrangement 100 may be resumed.

Power semiconductor module arrangements 100 often comprise at least one temperature sensor 210. A conventional arrangement comprising a temperature sensor 210 is schematically illustrated in Figure 2. Figure 2 illustrates a top view of an exemplary power semiconductor module arrangement 100. As has been described above, the power semiconductor module arrangement 100 may comprise at least one substrate 10 comprising a dielectric insulation layer and a first metallization layer. Different sections of the first metallization layer are not specifically illustrated in Figure 2 for the sake of simplicity only. A plurality of semiconductor dies 202n, 204n is mounted on the substrate 10. In Figure 2, a plurality of controllable semiconductor elements 2021, 2022, ..., 2026 such as, e.g., a plurality of transistor elements, is exemplarily illustrated as well as a plurality of diodes 2041, 2042, ..., 2046. Different semiconductor dies 202n, 204n may be electrically coupled to each other and/or to the substrate 10 by means of electrical connections 3. The arrangement of the different semiconductor dies 202n, 204n of the arrangement of Figure 2 with respect to each other is merely an example. A different number of semiconductor dies 202n, 204n as well as different kinds of semiconductor dies 202n, 204n may be arranged on the substrate 10 and may be electrically coupled to each other in any other suitable way.

A temperature sensor 210 is arranged on the substrate 10. The temperature sensor 210 is arranged close to the edge of the substrate 10. The power semiconductor module arrangement 100 further comprises terminal elements 4. In the arrangement illustrated in Figure 2, such terminal elements 4 are arranged at or close to the edges of the substrate 10. In Figure 2, a plurality of terminal elements 4 is illustrated. Some of the terminal elements 4 may be electrically coupled to one or more of the semiconductor dies 202n, 204n mounted on the substrate 10. Electrical connections between the terminal elements 4 and the semiconductor dies 202n, 204n however are not specifically illustrated in Figure 2 for the sake of simplicity. The arrangement illustrated in Figure 2 further comprises a pair of additional terminal elements 4. These additional terminal elements 4 are electrically coupled to the temperature sensor 210. That is, the additional terminal elements may be used to electrically contact the temperature sensor 210 from outside the power semiconductor module arrangement 100.

The temperature sensor 210 is configured to measure a temperature of the power semiconductor module arrangement 100. When the semiconductor dies 202n, 204n generate heat during the use of the power semiconductor module arrangement 100, the heat is transferred from the semiconductor dies 202n, 204n to the substrate 10 and further from the substrate 10 to the temperature sensor 210. That is, the temperature that is determined by the temperature sensor 210 is representative of a temperature of the power semiconductor module arrangement 100. However, in the arrangement illustrated in Figure 2, the determined temperature is only a rough approximation of the real temperature. That is, because the temperature sensor 210 is arranged distant from the semiconductor dies 202n, 204n. While the semiconductor dies 202n, 204n are arranged centrally on the substrate 10, the temperature sensor 210 is arranged close to an edge of the substrate 210. In this way, the temperature sensor 210 is arranged close to the additional terminal elements 4 provided to contact the temperature sensor 210. In the arrangement illustrated in Figure 2, the temperature sensor 210 is arranged closer to the diodes 2041, 2042, 2043 than, e.g., to the remaining diodes 2044, 2045, 2046. That is, a temperature of the diode 2046 which is arranged the farthest from the temperature sensor 210 cannot accurately be determined. Another drawback of the arrangement of Figure 2 is that the additional terminal elements 4 require space and add to the costs of the power semiconductor module arrangement 100.

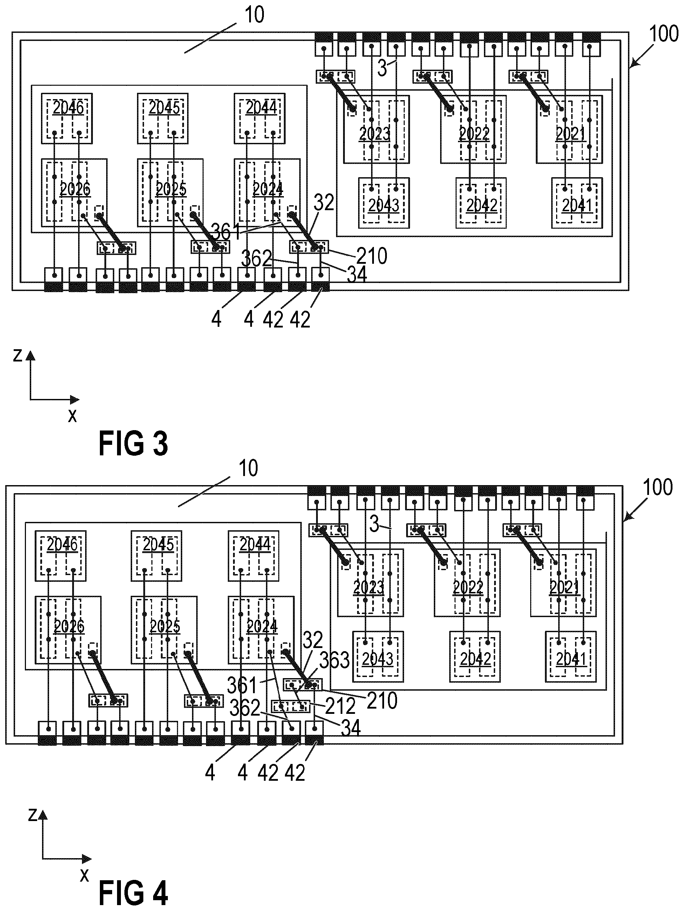

Therefore, in the example illustrated in Figure 3, a plurality of temperature sensors 210 is illustrated arranged closer to the semiconductor dies 202n, 204n. In particular, each temperature sensor 210 is arranged close to one of the semiconductor dies (controllable semiconductor element 2024 in Figure 3). Even further, each temperature sensor 210 is thermally and electrically coupled to a different one of the semiconductor dies 202n, 204n by means of a first connection piece 32. Each temperature sensor 210 is further electrically coupled to a sense terminal element 42 by means of a second connection piece 34. The first connection piece 32 may comprise a bonding wire or bonding ribbon, for example. In order to adequately thermally couple a temperature sensor 210 to the respective semiconductor die, a cross-sectional area of the first connection piece 32 may be large. That is, a maximum dimension such as a diameter (in case of a circular cross-section) or a maximum width or thickness (in case of other cross-sections, e.g., oval or angular) of the cross-section may be large. For example, if the first connection piece 32 comprises a bonding wire having a circular cross-section, the diameter of the first connection piece 32 may be between 100µm and 600µm. If the first connection piece 32 comprises a bonding ribbon having a rectangular cross-section, for example, the bonding ribbon may have a maximum dimension of the cross-section of between 500µm and 2000µm. The maximum dimension of a cross-section of a bonding ribbon may correspond to its width, for example. The thickness of a bonding ribbon usually has smaller dimensions that its width. A bonding ribbon having a rectangular cross-section may have a width of between 500µm and 2000µm, and a thickness of between 100µm and 600µm, for example. A side relation of width to thickness of a bonding ribbon may be between 5:1 and 3:1, for example.

The second connection piece 34 may also comprise a bonding wire or bonding ribbon, for example. A maximum dimension of the cross-section of the first connection piece 32 may be larger than a maximum dimension of the cross-section of the second connection piece 34. This is, because a thermal coupling is desired between the temperature sensor 210 and the respective semiconductor die 202n, 204n. However, a thermal coupling between the temperature sensor 210 and the sense terminal element 42 is not desired. Therefore, the second connection piece 34 should be thin as compared to the first connection piece 32. For example, if the second connection piece 34 comprises a bonding wire having a circular cross-section, the diameter of the second connection piece 34 may be between 10µm and 90µm. If the second connection piece 34 comprises a bonding ribbon having a rectangular cross-section, for example, the bonding ribbon may have a maximum dimension of the cross-section (e.g., width) of between 100µm and 400µm, and a thickness of between 20µm and 100µm, for example.

The first connection piece 32 couples the temperature sensor 210 to the respective semiconductor die 202n, 204n thermally as well as electrically. The second connection piece 34 couples the temperature sensor 210 to the sense terminal element 42 electrically. A certain thermal coupling between the temperature sensor 210 and the sense terminal element 42 via the second connection piece 34 cannot be avoided but is negligible due to its small cross-sectional area. The respective semiconductor die 202n, 204n is further electrically coupled to the temperature sensor 210 via a third connection piece 361, and the temperature sensor 210 is further electrically coupled to a further sense terminal element 42 via a fourth connection piece 362. The third and fourth connection piece 361, 362 may also each comprise a bonding wire or bonding ribbon, for example, that have similar dimensions as the second connection piece 34. That is, the third and fourth connection pieces 361, 362 are thin as compared to the first connection piece 32. The electrical connections provided by the first connection piece 32, the second connection piece 34, the third connection piece 361, and the fourth connection piece 362 allow to determine the temperature of the respective semiconductor die 202n, 204n. The semiconductor die 202n, 204n may comprise a control terminal and a load path between a first and a second load terminal, for example. A first bonding pad arranged on a top side of the semiconductor die 202n, 204n may form or may be connected to the control terminal. A second bonding pad arranged on the top side of the semiconductor die 202n, 204n may form or may be connected to the first load terminal. The top side of the semiconductor die 202n, 204n is a side that faces away from the substrate 10. A third bonding pad arranged on a bottom side of the semiconductor die 202n, 204n may form or may be connected to the second load terminal. The bottom side of the semiconductor die 202n, 204n is a side that faces the substrate 10. The first connection piece 32 may be electrically and thermally coupled to the first bonding pad of the semiconductor die 202n, 204n, and the third connection piece 361 may be electrically coupled to the second bonding pad of the semiconductor die 202n, 204n.

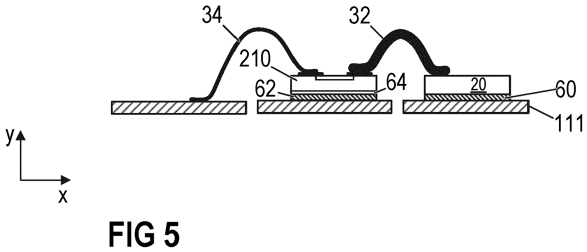

The temperature sensor 210 may comprise two separate bonding pads. One bonding pad for connecting the first connection piece 32 and the second connection piece 34, and another bonding pad for connecting the third connection piece 361 and the fourth connection piece 362. The two bonding pads are electrically and thermally coupled via the temperature sensor 210. This will be described in further detail with regard to Figure 5 below. For example, an electrical resistance of the temperature sensor 210 may depend on the temperature of the temperature sensor 210. That is, the resistance of the temperature sensor 210 may either increase or decrease when heat is transferred from the semiconductor die 202n, 204n to the temperature sensor 210 via the first connection piece 32. A current through the temperature sensor 210 may be determined, the current being dependent on the resistance of the temperature sensor 210. That is, a current through the temperature sensor 210 is indicative of a temperature of the temperature sensor 210. As the temperature sensor 210 is thermally coupled to one of the semiconductor dies 202n, 204n, a temperature of the temperature sensor 210 is indicative of a temperature of the respective semiconductor die 202n, 204n.

According to one example, at least one of the temperature sensors 210 comprises a negative temperature coefficient thermistor NTC. Other exemplary temperature sensors 210 comprise a positive temperature coefficient thermistor PTC, or a silicon chip, the electrical resistance of which depends on its temperature.

Summarizing the above, the respective semiconductor die 202n, 204n (e.g., a control terminal of the respective semiconductor die 202n, 204n) may be electrically coupled to a sense terminal element 42 via a first electrical connection. The first electrical connection may comprise the first connection piece 32 and the second connection piece 34, for example. The respective semiconductor die 202n, 204n (e.g., a first load terminal of the respective semiconductor die 202n, 204n) may be electrically coupled to another sense terminal element 42 via a second electrical connection. The second electrical connection may comprise the third connection piece 361 and the fourth connection pieces 362, for example. The temperature sensor 210, therefore, is coupled electrically in parallel to an internal path between the control terminal and the first load terminal (e.g., gate-emitter-path or gate-source-path) of the semiconductor die 202n, 204n.. In this way, no additional (sense) terminal elements 4, 42 are required to electrically contact the temperature sensor 210. On the contrary, the temperature sensor arrangement may take advantage of already existing (sense) terminal elements 42. The temperature sensor arrangement may be integrated in an existing design without requiring excessive space.

In Figure 3, a plurality of temperature sensors 210 is schematically illustrated. In particular, the number of temperature sensors 210 illustrated in Figure 3 corresponds to the number of controllable semiconductor elements 202n. In this way, the temperature of each of the controllable semiconductor elements 202n may be monitored with a separate one of the plurality of temperature sensors 210. This, however, is only an example. In some cases, the temperature of each of the controllable semiconductor elements 202n, 204n may have to be monitored. This, however, may not be necessary for other cases. According to another example, the arrangement comprises at least one temperature sensor 210, but the number of temperature sensors 210 is less than the number of controllable semiconductor elements 202n. Additionally or alternatively, it is also possible that a temperature of one or more of the diodes 204n is monitored by means of a temperature sensor 210.

Now referring to Figure 4, the temperature sensor arrangement may further comprise a resistive element 212 coupled in series with one of the temperature sensors 210 between the first bonding pad and the second bonding pad (e.g., between the control terminal and the first load terminal) of the respective semiconductor die 202n, 204n. If, for example, the electrical resistance of the temperature sensor 210 decreases when the temperature of the temperature sensor 210 increases, the resulting electrical resistance of the temperature sensor 210 at high temperatures may be too low. For example, at high temperatures the electrical resistance of the temperature sensor 210 may be less than 2kQ, or even 1kΩ or less. Typical measuring currents may be in the range of several milliamperes. In order to provide an overall resistance of about 10kΩ even at high temperatures for the overall temperature sensor arrangement, a resistive element 212 may have a resistance of between 8kQ and 9.5kQ, for example.

The resistive element 212 may be electrically coupled to the temperature sensor 210 by means of a fifth connection piece 363. In the example illustrated in Figure 4, the resistive element 212 is arranged between the temperature sensor 210 and the third connection piece 361, and the fourth connection piece 362, respectively. That is, the respective semiconductor die 202n, 204n is electrically coupled to the resistive element 212 via the third connection piece 361, instead of to the temperature sensor 210 as in the example of Figure 3. The fourth connection piece 362 is connected to the resistive element 212 and the further sense terminal element 42. It is, however, also possible to arrange the resistive element 212 between the temperature sensor 210 and the first connection piece 32. That is, the resistive element 212, instead of the temperature sensor 210, may be electrically contacted by the second connection piece 34 (as illustrated in Figure 4) and by the first connection piece 32. The temperature sensor 210, on the other hand, may then be electrically contacted by the third and the fourth connection piece 361, 362.

The temperature sensor arrangement described above cannot only be used to determine the temperature of a controllable semiconductor element 2021, 2022, ..., 2026. In the same way it is also possible to determine the temperature of a diode 2041, 2042, ..., 2046, for example. That is, the temperature sensor arrangement can also be arranged between an anode terminal or a cathode terminal of a diode and respective sense terminal elements 42. Generally speaking, the temperature sensor arrangement may be used to determine the temperature of any kind of semiconductor element without the need for additional (sense) terminal elements 4, 42. In Figure 4, only one resistive element 212 is exemplarily illustrated. It is, however, also possible that the arrangement comprises more than one resistive element 212, wherein each of the resistive elements 212 is electrically coupled to a different one of the temperature sensors 210.

Now referring to Figure 5, the temperature sensor 210 may be arranged on the first metallization layer 111 of a substrate 10. In the example illustrated in Figure 5, the temperature sensor 210 is arranged on a different section of the first metallization layer 111 as the respective semiconductor die 20. This, however, is only an example. It is also possible that the temperature sensor 210 is arranged on the same section of the first metallization layer 111 as the semiconductor die 20. Arranging the temperature sensor 210 on the same section of the first metallization layer 111 as the semiconductor die 20 may result in a more space-saving design as compared to an arrangement wherein the temperature sensor 210 is arranged on a different section of the first metallization layer 111 as the semiconductor die 20. A connection layer 62 may be arranged between the temperature sensor 210 and the first metallization layer 111. The temperature sensor 210 may comprise a dielectric insulation layer 64, for example, that is configured to dielectrically insulate the temperature sensor 210 from the connection layer 62 and the first metallization layer 111. In the example illustrated in Figure 5, the dielectric insulation layer 64 is illustrated as a comparatively thin layer. The dielectric insulation layer 64, however, may also be a thicker layer. Because of this dielectric isolation, the temperature sensor 210 may be arranged on any section of the first metallization layer 111, irrespective of an electrical potential the respective section is coupled to. For example, the temperature sensor 210 may be arranged on a section of the first metallization layer 111 irrespective of whether the respective section is electrically coupled to a high-voltage potential.

The dielectric insulation layer 64, however, may also be omitted. In that case, however, no dielectric insulation between the temperature sensor 210 and the first metallization layer 111 is provided. Without a dielectric isolation, the temperature sensor 210 may not be coupled to any arbitrary section of the first metallization layer 111. Using a temperature sensor 210 that is not dielectrically insulated may require a separate section of the first metallization layer 111 on which only the temperature sensor 210 (bot not the semiconductor die 20 or any other components) is arranged. This, however, requires additional space.

The temperature sensor 210 further comprises a layer of sensor material 70. The first bonding pad to which the first connection piece 32 is connected, and the second bonding pad to which the second connection piece 34 is connected, are electrically coupled via the layer of sensor material 70. An electrical resistance of the layer of sensor material 70 may depend on the temperature of the temperature sensor 210. That is, the resistance of the layer of sensor material 70 may either increase or decrease when heat is transferred from the semiconductor body 202n, 204n to the temperature sensor 210 via the first connection piece 32.

The connection layer 62 may form a permanent mechanic connection between the temperature sensor 210 and the first metallization layer 111. For example, the connection layer 62 may be a solder layer or a layer of an adhesive material. Any materials may be used to form the connection layer 62 that may form a permanent connection between the temperature sensor 210 and the first metallization layer 111. According to one example, the connection layer 62 comprises silicone.

According to an even further example (not specifically illustrated), the temperature sensor 210 may not be arranged on the first metallization layer 111 but on the respective semiconductor die 20 instead. Irrespective of whether the temperature sensor 210 is arranged close to or on the semiconductor die 20, the temperature sensor 210 may be thermally coupled to the semiconductor die 20 by means of a first connection piece 32, as has been described above. The surface area of the temperature sensor 210 may be smaller than the surface area of the semiconductor die 20. In this way, even when mounted on the semiconductor die 20, the temperature sensor 210 does not completely cover the semiconductor die 20. A sufficiently large surface area of the semiconductor die 20 remains to provide enough space for connecting the first connection piece 32 and the third connection piece 361 as well as further electrical connections 3 that are used to electrically contact the semiconductor die 20. A dielectric insulation layer 64 in such a case may provide a dielectric insulation between the temperature sensor 210 and the semiconductor die 20.

The arrangements in Figures 3 and 4 each comprise a plurality of temperature sensor arrangements. Each temperature sensor arrangement is configured to detect a temperature of the power semiconductor module arrangement 100, e.g., the temperature of one of the semiconductor dies 20. Generally, however, it is possible that the power semiconductor module arrangement 100 comprises fewer, but at least one temperature sensor arrangement. If the power semiconductor module arrangement 100 comprises more than one temperature sensor arrangement, each temperature sensor arrangement may be configured to measure a temperature at a different measuring position than the other temperature sensor arrangements. For example, each temperature sensor arrangement may be configured to monitor the temperature of a different one of the semiconductor dies 20. That is, each temperature sensor arrangement may be thermally coupled to one of the semiconductor dies 20 by means of a separate first connection piece 32, and to a sense terminal element 42 by means of a separate second connection piece 34. The respective sense terminal elements 42 may protrude out of the housing 7 of the power semiconductor module arrangement 100 and may be coupled to one or more external evaluation units.

## Claims

1. A power semiconductor module arrangement (100) comprising:
a substrate (10) comprising a dielectric insulation layer (11), and a first metallization layer (111) arranged on a first side of the dielectric insulation layer (11);
at least one semiconductor die (20) mounted on the first metallization layer (111) of the substrate (10); and
at least one temperature sensor arrangement, wherein
each of the at least one temperature sensor arrangement comprises a temperature sensor (210), a first connection piece (32), thermally and electrically coupling the temperature sensor (210) to one of the at least one semiconductor die (20), and a second connection piece (34), electrically coupling the temperature sensor (210)
to a first sense terminal element (42), and
a maximum dimension of a cross-section of the first connection piece (32) of each of the at least one temperature sensor arrangement is greater than a maximum dimension of a cross-section of the respective second connection piece (34).

2. The power semiconductor module arrangement (100) of claim 1, wherein
the first connection piece (32) comprises a bonding wire or bonding ribbon; and the second connection piece (34) comprises a bonding wire or bonding ribbon.

3. The power semiconductor module arrangement (100) of claim 2, wherein
the first connection piece (32) comprises a bonding wire having a diameter of between 100µm and 600µm, or a bonding ribbon having a width of between 500µm and 2000µm and a thickness of between 100µm and 600µm; and
the second connection piece (34) comprises a bonding wire having a diameter of between 10µm and 90mm, or a bonding ribbon having a width of between 100µm and 400µm and a thickness of between 20µm and 100µm.

4. The power semiconductor module arrangement (100) of any of claims 1 to 3, wherein each of the at least one temperature sensor (210) has an electrical resistance which varies depending on a temperature of the respective temperature sensor (210).

5. The power semiconductor module arrangement (100) of claim 4, wherein each of the at least one temperature sensor (210) comprises a negative temperature coefficient thermistor, a positive temperature coefficient thermistor, or a silicon chip.

6. The power semiconductor module arrangement (100) of any of claims 1 to 5, wherein at least one of the at least one temperature sensor (210) is mounted on the first metallization layer (111) of the substrate (10).

7. The power semiconductor module arrangement (100) of any of claims 1 to 6, wherein at least one of the at least one temperature sensor (210) is mounted on one of the at least one semiconductor die (20).

8. The power semiconductor module arrangement (100) of claim 6 or 7, wherein each of the at least one temperature sensor arrangements further comprises a layer of electrically insulating material (62) arranged between the respective temperature sensor (210) and the first metallization layer (111) or between the respective temperature sensor (210) and the respective semiconductor die (20).

9. The power semiconductor module arrangement (100) of any of the preceding claims, wherein
each of the at least one semiconductor die (20) comprises a control terminal and a load path between a first and a second load terminal,
the control terminal of each of the at least one semiconductor die (20) is electrically coupled to a first bonding pad of the temperature sensor (210) by means of the first connection piece (32),
the first sense terminal element (42) is electrically coupled to the first bonding pad of the temperature sensor (210) by means of the second connection piece (34),
the first load terminal of each of the at least one semiconductor die (20) is electrically coupled to a second bonding pad of the temperature sensor (210) by means of a third connection piece (361),
a second sense terminal element (42) is electrically coupled to the second bonding pad of the temperature sensor (210) by means of a fourth connection piece (362), and
each of the at least one temperature sensors (210)is coupled in parallel to an internal path between the control terminal and the first load terminal.

10. The power semiconductor module arrangement (100) of any of the preceding claims, wherein each of the at least one temperature sensor arrangements further comprises at least one resistive element (212) coupled in series with the respective temperature sensor (210).

11. The power semiconductor module arrangement (100) of claim 10, wherein each of the at least one resistive element (212) has a resistance of between 8kQ and 9.5kQ.

12. The power semiconductor module arrangement (100) of claim 10 or 11, wherein each of the at least one resistive elements (212) is electrically coupled between one of the at least one temperature sensor (210) and the respective third and fourth connection piece (361, 362).

13. The power semiconductor module arrangement (100) of claim 10 or 11, wherein each of the at least one resistive elements (212) is electrically coupled between one of the at least one temperature sensor (210) and the load terminal of the respective semiconductor die (20).
